# EUROPEAN PATENT APPLICATION

(11) **EP 2 650 674 A1**
(43) Date of publication of application: **16.10.2013**
(21) Application number: 13163502.1
(22) Date of filing: 12.04.2013
(51) Int. Cl.: G01N 21/95, G01N 21/956, G01N 21/93, H01L 31/0224

(54) **Method to control the printing of a pattern printed on a substrate**

(30) Priority: 13.04.2012 IT UD20120061; 07.09.2012 US 201261698141 P
(71) Applicant: APPLIED MATERIALS ITALIA S.R.L., 31048 San Biagio di Callalta (TV) (IT)
(72) Inventor: Boscolo, Enrico Marchi, 30015 Chioggia Venice (IT); Vercesi, Tommaso, 31057 Silea (IT); Romanello, Alberto, 31030 Mignagola di Carbonera TV (IT)
(74) Representative: Zimmermann & Partner

(57) **Abstract**

The present invention provides a method and apparatus to control the printing of a pattern printed on a substrate, such as a wafer to form photovoltaic cells or circuits of the green-tape type. In one embodiment, a method to control the printing of a pattern printed on a substrate includes printing on a surface of the substrate a plurality of print tracks to define the pattern, by means of optical acquisition verifying the printing of the print tracks on the substrate. Verifying comprises acquiring a first reference optical image (**301**) of the surface of the substrate, or reference substrate, by means of an inspection unit, carried out before printing; processing the first image, in which a processing unit or controller determines reference geometric coordinates (**X1,Y1**, **X2,Y2**, **X3,Y3**, **X4,Y4**) of the first image and memorizes the geometric coordinates; subsequent to the printing, by means of the inspection unit, acquiring a second image (**303**) of the surface of the substrate on which the print tracks (**302**) are printed; processing the second image by means of the processing unit or controller that associates the geometric reference coordinates of the first image to the second image; the processing unit or controller subtracting point by point the colorings between the first image and the second image to obtain a third image (**307**), in which the differences between the first image and the second image are displayed.

## Description

### BACKGROUND OF THE INVENTION

### Field of the Invention

Embodiments of the present invention generally relate to a method and apparatus to control, by means of optical acquisition, the printing of a pattern printed on a substrate or support, which can be used to form a photovoltaic cell or a green-tape type circuit device. In particular, the method according to the present invention can be used in a system for producing multilayer patterns by means of multilayer printing on a substrate, whether it be by screen printing, ink-jet printing, laser printing or other type of printing.

### Description of the Related Art

Solar cells are photovoltaic (PV) devices that convert sunlight directly into electrical power. The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form the solar cells by improving the device yield and increasing the substrate throughput.

Methods for producing solar cells are known, and configure solar cells with one or more p-n junctions. Each p-n junction comprises two different regions within a semiconductor material where one side is denoted as the p-type region and the other as the n-type region. When the p-n junction of a solar cell is exposed to sunlight, the sunlight is directly converted to electricity through the PV effect. Solar cells generate a specific amount of electric power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of n-type silicon on top of a p-type region formed on the substrate.

Generally, a standard silicon solar cell is fabricated on a wafer which includes a p-type base region, an n-type emitter region, and a p-n junction region disposed therebetween. An n-type region, or n-type semiconductor, is formed by doping the semiconductor with certain types of elements (*e.g.*, phosphorus (P), arsenic (As), or antimony (Sb)), in order to increase the number of negative charge carriers, *i.e.*, electrons. Similarly, a p-type region, or p-type semiconductor, is formed by the addition of trivalent atoms to the crystal lattice, resulting in a missing electron from one of the four covalent bonds normal for the silicon lattice. Thus the dopant atom can accept an electron from a neighboring atoms covalent bond to complete the fourth bond. The dopant atom accepts an electron, causing the loss of half of one bond from the neighboring atom and resulting in the formation of a "hole".

When light falls on the solar cell, energy from the incident photons generates electron-hole pairs on both sides of the p-n junction region. Electrons diffuse across the p-n junction to a lower energy level, and holes diffuse in the opposite direction, creating a negative charge on the emitter and a corresponding positive charge builds up in the base. When an electrical circuit is made between the emitter and the base and the p-n junction is exposed to certain wavelengths of light, a current will flow. The electrical current generated by the semiconductor when illuminated flows through contacts disposed on the frontside, *i.e.,* the light-receiving side, and the backside of the solar cell. The top contact structure is generally configured as widely-spaced thin metal lines, or fingers, that supply current to larger bus bars. The back contact is generally not constrained to be formed in multiple thin metal lines, since it does not prevent incident light from striking solar cell. Solar cells are generally covered with a thin layer of dielectric material, such as Si₃N₄, to act as an antireflection coating, or ARC, to minimize light reflection from the top surface of solar cell.

Screen printing has long been used in printing designs on objects, such as cloth or ceramics, and is used in the electronics industry for printing electrical component designs, such as electrical contacts or interconnects on the surface of a substrate. State of the art solar cell fabrication processes also use screen printing processes. In some applications, it is desirable to screen print contact lines, such as fingers, on the solar cell substrate. The fingers are in contact with the substrate and are adapted to form an Ohmic connection with one or more doped regions (*e.g.*, n-type emitter region). An Ohmic contact is a region on a semiconductor device that has been prepared so that the current-voltage (I-V) curve of the device is linear and symmetric, *i.e.,* there is no high-resistance interface between the doped silicon region of the semiconductor device and the metal contact. Low-resistance, stable contacts are critical for the performance of the solar cell and reliability of the circuits formed in the solar cell fabrication process.

A heavily doped region may be formed on the substrate surface using a variety of patterning techniques to create areas of varied doping, for example by performing phosphorus diffusion steps using a patterned diffusion barrier. A backside contact completes the electrical circuit required for solar cell to produce a current by forming an Ohmic contact with p-type base region of the substrate. To enhance the contact with the solar cell device it is typical to position a finger on the heavily doped regions formed within the substrate surface to enable the formation of an Ohmic contact. Since the formed heavily doped regions, due to their electrical properties, tend to block or minimize the amount of light that can pass there through, it is desirable to minimize their size, while also making these regions large enough to assure that the fingers can be reliably aligned and formed thereon.

Formation of the heavily doped region and the finger may comprise deposition of multiple, successive layers of material. The misalignment of the layers forming the heavily doped region may cause the surface area of the heavily doped region to be larger than what is necessary and prevent passage of light that would otherwise be available to the solar cell. Additionally, misalignment of the deposited fingers to the underlying heavily doped regions can lead to poor device performance and low device efficiency. The misalignment in the formation of the heavily doped region and the finger may be due to errors in the positioning of the substrate on an automated transferring device, defects in the edge of the substrate, unknown registration and alignment of the heavily doped region on the substrate surface and/or shifting of the substrate on the automated transferring device. Consequently, in the event of a large enough error during a printing process step, the misalignment of the printed multiple layers will cause the substrate to be discarded.

Within this field, it is known to produce solar cells on a crystalline silicon base by means of the screen printing technique described above, by means of ionic implant techniques, or other techniques to achieve on the front and/or rear surface of the solar cells a structure of selective emitters. During the printing steps there is a need for one or more control steps after each printing step, to verify the alignment of the layers printed on each occasion with respect to the layers below, or to verify the printing alignment with respect to the print surface. The control steps are carried out through the direct acquisition of the image of the substrate on which the patterned layer has been deposited, and are compared with a reference image in order to determine possible discrepancies. Subsequently, closed-ring retroaction calculations are carried out, to regulate or correct the position of the subsequent print or prints.

It is also known that on the back surface of the substrate Ohmic contacts, or bus bars, of the photovoltaic cell are printed, which are usually gray and have a shade that does not contrast very much with the coloring of the back surface of the substrate. After the contacts have been printed, which is usually achieved by depositing conductive paste of silver and/or aluminum, a layer of aluminum is deposited on the back surface itself and in the zones not occupied by the contacts. The last printing is difficult to distinguish from the contacts previously deposited because, also this last case, of the limited chromatic differences.

It is also known that during the successive printing processes that are carried out, it is necessary to control the correct execution of the printing by acquiring images. In the known acquisition technique, the layer that is deposited according to a pattern is hardly distinguishable from the surface of the substrate and/or from the contacts previously printed.

It is also known that the conductive material can also be printed on the upper or front surface of the substrate, as well as on the lower surface as specified above. In this case the contrast between the upper surface and the printed portions is much more accentuated and therefore the disadvantage connected to the poor distinguishability of the print surface with respect to the print tracks is obviated. In this case however, it is difficult to determine possible print defects such as for example the misalignment of the print tracks deposited with respect to the cell surfaces, or possible spots or print defects.

Therefore, there is a need to achieve a method for the optical acquisition of images relating to a pattern printed on a substrate which is efficient and allows to distinguish the printed pattern from the surface on which it is printed.

There is also a need to perfect a method for the optical acquisition of a printed substrate which allows to detect possible printing imperfections so as to be able to intervene in order to eliminate the imperfections.

### SUMMARY OF THE INVENTION

Embodiments of the present invention provide a method to control the printing of a pattern printed on a substrate, which can be used to form a photovoltaic cell or a green-tape type circuit device. The method comprises a printing step of a plurality of print tracks on a surface of the substrate so as to define the pattern, and a verification step, by means of optical acquisition, of the printing of the print tracks on the substrate. The verification step is aimed to verify both the correct position of the print tracks with respect to the substrate and also possible printing imperfections.

The method further provides that the verification step comprises:
- a first sub-step of acquiring a first reference optical image of the surface of the substrate which will be printed during the printing step, or of a reference substrate, by means of an optical inspection unit, carried out before the printing step;
- a second sub-step of processing the first reference optical image, in which a processing unit or controller determines reference geometric coordinates of the first image such as, for example, the center of the substrate, the coordinates of the vertexes of the substrate, or other, and memorizes all the geometric coordinates in a memory;
- a third sub-step, subsequent to the printing step, in which the optical inspection unit acquires a second image of the surface of the substrate on which the print tracks are printed;
- a fourth sub-step of processing the second image in which the processing unit or controller associates the geometric reference coordinates of the first image to the second image, so that it is possible to determine a total overlapping of the first and second image; and
- a fifth sub-step of comparison during which the processing unit or controller carries out a punctual subtraction of the colorings of the first image and the second image to obtain a third image, in which the differences between the two images are displayed.

With the present invention it is therefore possible to have a comparison between the print tracks that have been deposited, and hence to determine the reciprocal position thereof with respect to the substrate; moreover, it is also possible to determine possible printing imperfections, such as for example spots, print interruptions, or misalignments of the print tracks.

The fifth comparison sub-step allows to eliminate possible disturbing colorings that would not allow the inspection unit to determine univocally the positions of the print tracks or of possible printing imperfections. In the specific case of detecting the position of the print tracks, the fifth sub-step allows to overcome the disadvantage that the colorings of the substrate surface cannot be distinguished from the print tracks, given the reduced and slight chromatic differences.

In another embodiment, during the second sub-step and the fourth sub-step, the controller divides both the first image and the second image into the same plurality of elementary image units, and during the fifth sub-step each of the elementary units of the first image is subtracted from a corresponding elementary unit of the second image; in this way, by overlapping the two images, identical colorings are canceled and different colorings are highlighted, and are easily distinguishable each other.

In another embodiment, when it is necessary to control the print position of the print tracks with respect to the substrate, during the first acquisition step, the first image is acquired, relating to the surface of the substrate on which the print tracks will be printed in the subsequent printing step.

In another embodiment, the second image is defined at least by a first zone corresponding to the non-printed surface of the substrate, and a plurality of second zones corresponding to the print tracks deposited on the substrate. The at least one first zone and the plurality of second zones acquired by the inspection unit have a similar tonality of colors, and therefore they are difficult to distinguish by the inspection unit except after the processing performed by the controller.

In another embodiment, the third image obtained following the comparison by subtraction of the first and second image is defined by at least a third zone corresponding to the non-printed surface of the substrate, and by a plurality of fourth zones corresponding to the print tracks deposited on the substrate; the third zone and the plurality of fourth zones are distinguishable from each other. Indeed, since the third image is obtained by a punctual subtraction of the coloring of the first and second image, the third image includes the above-defined third zone, corresponding to the non-printed zone; the non-printed zone is for example black, given that identical colors are subtracted; the printed zone, corresponding to the fourth zone, is therefore highlighted and easily distinguishable. In the fifth sub-step, the controller determines contours of the fourth zones and determines pairs of coordinates which can be associated to the contours in order to evaluate the position assumed by the print tracks with respect to the reference geometric coordinates.

In another embodiment, the first acquisition step provides to acquire the first image relating to a surface of a reference substrate on which print tracks have been deposited in an optimum manner. This image is considered as a sample image, and it is with respect to this that the comparison is carried out on the possible printing imperfections such as the presence of spots, interruptions in the print tracks, or possible misalignments, which occur on the substrates which are printed on each occasion. In this case, in the third image acquired, only the zones corresponding to the surface of the substrate where there are printing imperfections are displayed.

In another embodiment, before the printing step and the verification step a calibration step is provided in which an absolute Cartesian reference system is determined in order to evaluate at least the reference geometric coordinates.

In another embodiment, the calibration step provides to detect, by means of the inspection unit, a sample image relating to a calibration substrate on which reference elements are transferred.

In another embodiment, the reference elements comprise a plurality of balls printed in predetermined positions and according to a matrix configuration.

In another embodiment, the reference elements comprise a shaped element made in a central position of the calibration substrate and is provided with two sides disposed orthogonal with respect to each other.

Embodiments of the present invention provide an apparatus to control the printing of a pattern printed on a substrate; in one embodiment, the apparatus comprises at least a printing station, such as a printing nest, adapted to deposit on the surface of the substrate a plurality of print tracks to define the pattern, and an optical inspection unit to acquire the first and second image.

The apparatus further comprises a processing unit or controller provided with processing means, *i.e.,* a processor, adapted to process the first and second image and to associate with the images reference geometric coordinates as described above. The processing means are also adapted to compare the first image and the second image, by means of a punctual subtraction of the respective colorings so as to obtain a third image, in which the differences between the first image and the second image are displayed.

### BRIEF DESCRIPTION OF THE DRAWINGS

These and other characteristics of the invention will become apparent from the following description of a preferential form of embodiment, given as a non-restrictive example with reference to the attached drawings wherein:

Figure 1 is an isometric schematic view of a system that can be used in connection with some embodiments of the present invention;

Figure 2 is a top plan schematic view of the system in Figure 1 according to one embodiment of the present invention;

Figure 3 is an isometric schematic view of another system that can be used in connection with some embodiments of the present invention;

Figure 4 is a top plan schematic view of the system in Figure 3 according to one embodiment of the present invention;

Figure 5 is an isometric schematic view of another system that can be used in connection with some embodiments of the present invention;

Figure 6 is a top plan schematic view of the system in Figure 5 according to one embodiment of the present invention;

Figure 7 is an isometric view of a portion of the printing nest of the screen printing system according to one embodiment of the present invention;

Figure 8 is an isometric schematic view of one embodiment of a rotary actuator unit having an inspection unit positioned to inspect the front surface of the substrate;

Figure 9 is a schematic representation exemplifying a first embodiment of the method according to the present invention;

Figure 10 is a schematic representation of a substrate used for the calibration of images acquired during the method according to the present invention;

Figure 11 is a schematic representation exemplifying a second embodiment of the method according to the present invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present invention provide a method and apparatus to control the printing of a pattern printed on a substrate, which can be applied on a screen printing system, or system 110, to form the metal contacts in a desired pattern on a surface of a solar cell substrate 250.

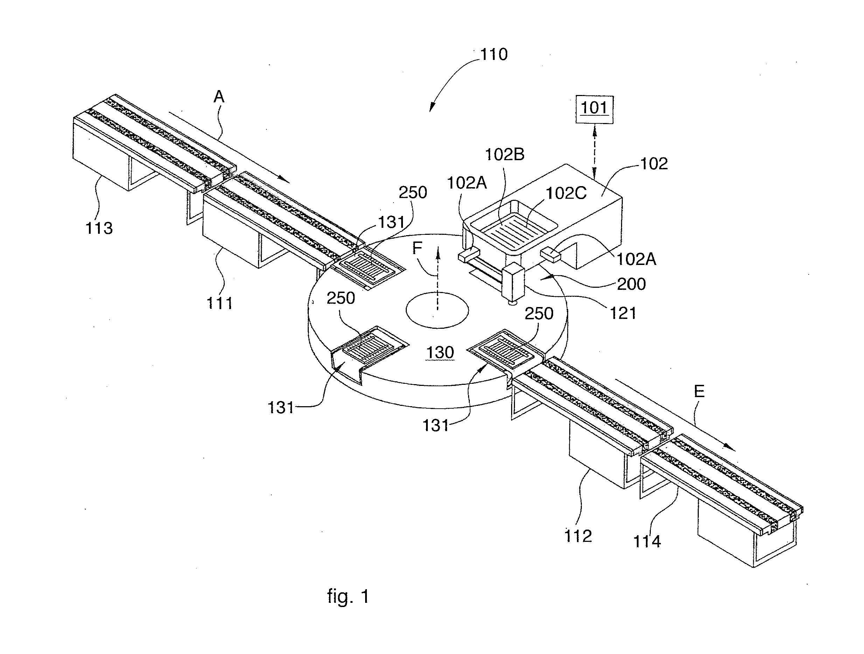

In one embodiment (Figure 1), the screen printing system 110 comprises an incoming conveyor 111, a rotary actuator assembly 130, a screen print chamber 102, and an outgoing conveyor 112. The incoming conveyor 111 may be configured to receive the substrate 250 from an input device, such as an input conveyor 113 (*i.e.*, path "A" in Figure 1), and transfer the substrate 250 to a printing nest 131 coupled to the rotary actuator assembly 130. The outgoing conveyor 112 may be configured to receive a processed substrate 250 from a printing nest 131 coupled to the rotary actuator assembly 130 and transfer the substrate 250 to a substrate removal device, such as an exit conveyor 114 (*i.e.*, path "E" in Figure 1). The input conveyor 113 and the exit conveyor 114 may be automated substrate handling devices that are part of a larger production line.

The rotary actuator assembly 130 may be rotated and angularly positioned about the "F" axis by a rotary actuator (not shown) and a system controller 101, such that the printing nests 131 may be selectively angularly positioned within the screen printing system 110 (*e.g.*, paths "D1" and "D2" in Figure 1). The rotary actuator assembly 130 may also have one or more supporting components to facilitate the control of the printing nests 131 or other automated devices used to perform a substrate processing sequence in the screen printing system 110.

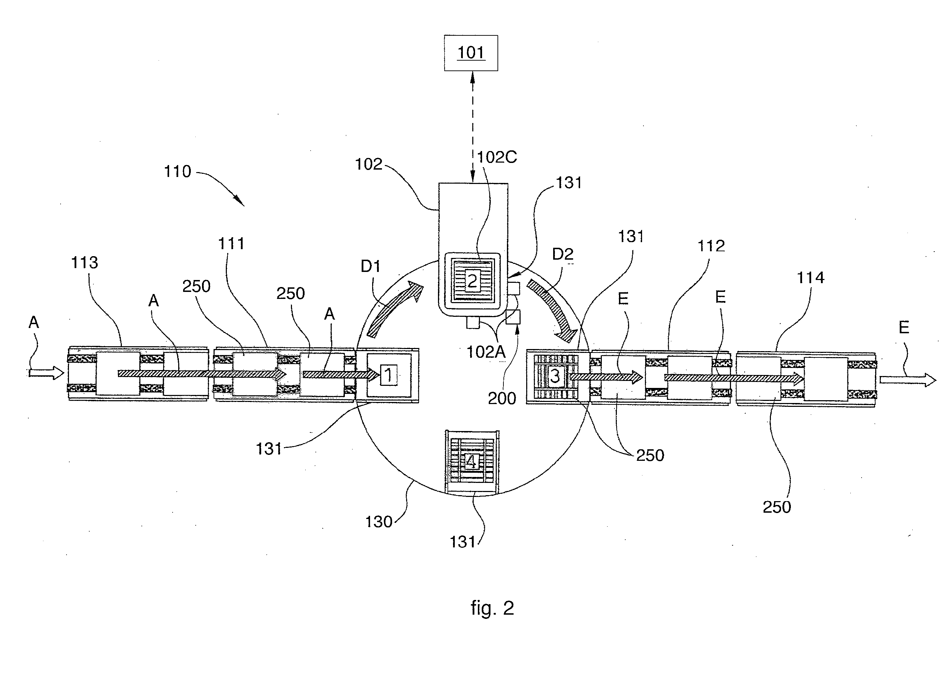

In one embodiment (Figure 1), the rotary actuator assembly 130 includes four printing nests 131, or substrate supports, that are each adapted to support a substrate 250 during the screen printing process performed within the screen print chamber 102. Figure 2 schematically illustrates the position of the rotary actuator assembly 130 in which one printing nest 131 is in position "1" to receive a substrate 250 from the incoming conveyor 111, another printing nest 131 is in position "2" within the screen print chamber 102 so that another substrate 250 can receive a screen printed pattern on a surface thereof, another printing nest 131 is in position "3" for transferring a processed substrate 250 to the outgoing conveyor 112, and another printing nest 131 is in position "4", which is an intermediate stage between position "1" and position "3".

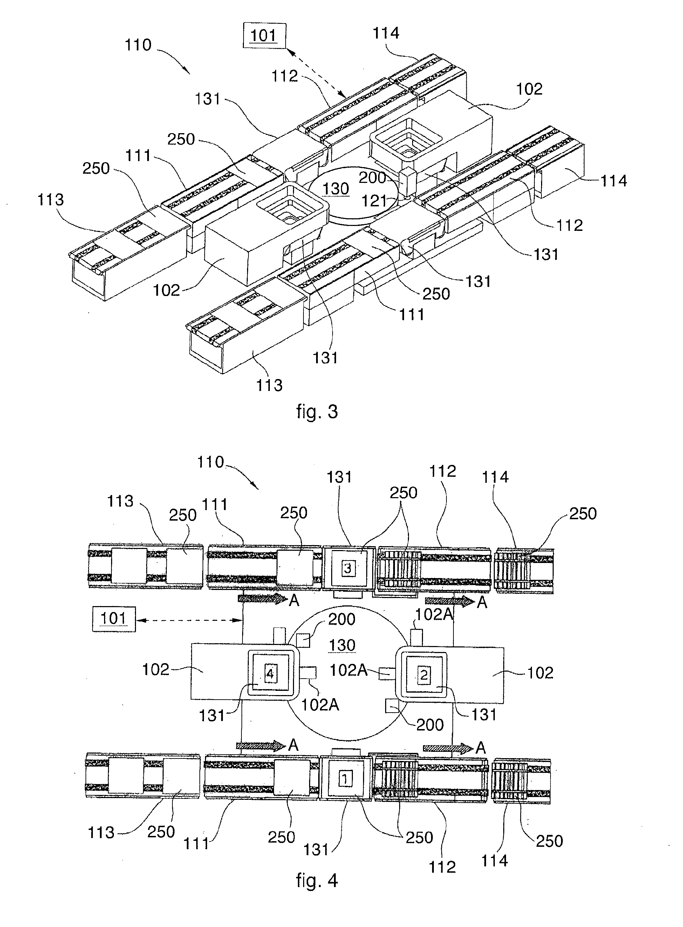

Figure 3 is an isometric schematic view and Figure 4 is a top plan schematic view that show another embodiment of the screen printing system, or system 110, that can be used also in conjunction with embodiments of the present invention to form the metal contacts in a desired pattern on the surface of the solar cell substrate 250.

In one embodiment, the system 110 in Figures 3 and 4 generally comprises two incoming conveyors 111 and an actuator assembly 130 that is configured as a rotary table or rotary actuator. The system 110 also includes a plurality of printing nests 131, a plurality of screen print chambers 102, two outgoing conveyors 112, and a system controller 101. The incoming conveyors 111 are configured in a parallel processing configuration so that each can receive unprocessed substrates 250 from an input device, such as an input conveyor 113, and transfer each unprocessed substrate 250 to a printing nest 131 coupled to the actuator assembly 130. In addition, the outgoing conveyors 112 are configured parallel so that each can receive a processed substrate 250 from a printing nest 131 and transfer each processed substrate 250 to a substrate removal device, such as an exit conveyor 114.

In one embodiment, the screen printing system 110 in Figures 3 and 4 has two printing nests 131 (in positions "1" and "3") each positioned both to transfer a processed substrate 250 to the outgoing conveyor 112 and also to receive a non-processed substrate 250 from the incoming conveyor 111.

Thus, in the system 110 the movement of the substrate generally follows the path "A". In this configuration, each of the two other printing nests 131 (in positions "2" and "4") is positioned under the screen print chamber 102, so that screen printing can be carried out on the non-processed substrates 250 located on the respective printing nests 131.

This parallel processing configuration allows to increase productive capacity with a minimum bulk of the processing system. Although the system 110 is illustrated in Figures 3 and 4 with two screen print chambers 102 and four printing nests 131, the system 110 can comprise additional screen print chambers 102 and/or printing nests 131, without departing from the field of the present invention.

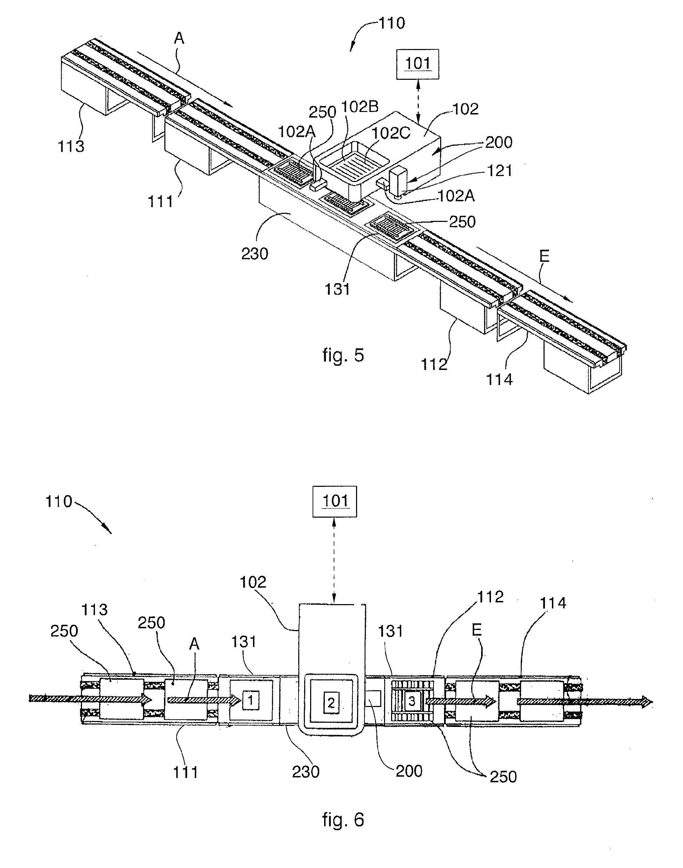

Figure 5 is an isometric schematic view and Figure 6 is a top plan schematic view which show another embodiment of a screen printing system, or system 101, which can be used also in conjunction with embodiments of the present invention to form the metal contacts in a desired pattern on the surface of a solar cell substrate 250.

In one embodiment, the screen printing system 110 in Figures 5 and 6 comprises an incoming conveyor 111, an actuator assembly 230, which is configured as a linear movement unit in this embodiment, a screen print chamber 102, an outgoing conveyor 112 and a system controller 101. The incoming conveyor 111 can be configured to receive a substrate 250 from an input device, such as an input conveyor 113 (*i.e*., path "A" in Figures 5 and 6), and transfer the substrate 250 to a printing nest 131 coupled at inlet to the actuator assembly 230. The outgoing conveyor 112 can be configured to receive a processed substrate 250 from a printing nest 131 coupled at exit to the actuator assembly 230 and transfer the substrate 250 to a substrate removal device, such as an exit conveyor 114 (*i.e.,* path "E" in Figures 5 and 6). The input conveyor 113 and the exit conveyor 114 may be automated substrate handling devices that are part of a larger production line.

The incoming conveyor 111 transports the substrates 250 from position "1" (Figure 6) in which a substrate 250 is introduced into the screen print chamber 102, a position "2" inside the screen print chamber 102, and a third position "3" in which the processed substrate 250 is discharged from the screen print chamber 102 and conveyed to other operating stations. In the case of a double or multiple print, the substrate 250 is again introduced into the screen print chamber 102 in position "2" to carry out a second or further printing step and is then discharged again from the screen print chamber 102 passing to position "3". This alternate movement is repeated a number of times coordinated with the number of layers to be printed, until the final product is definitively discharged.

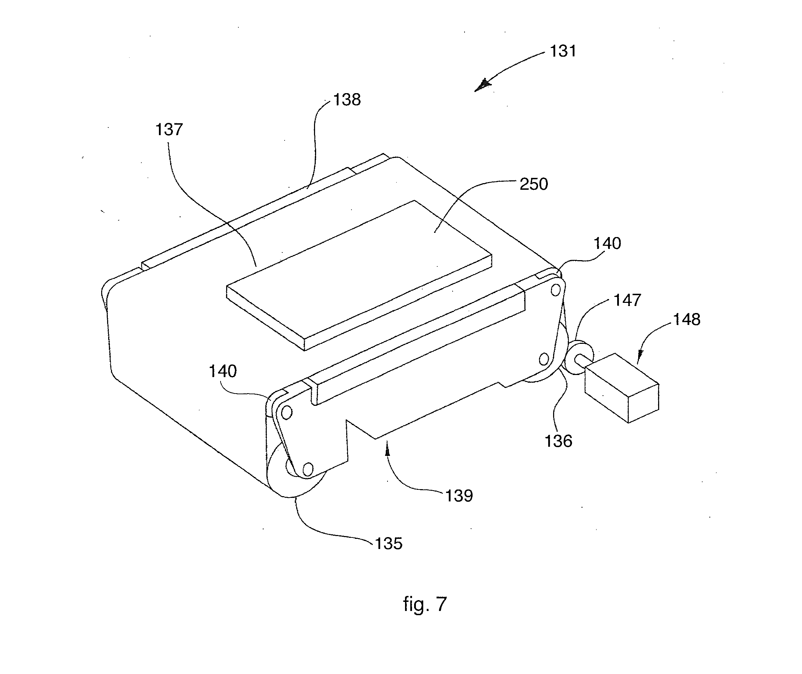

As illustrated in Figure 7, a printing nest 131 generally consists of a conveyor assembly 139 that has a feed spool 135, a take-up spool 136, rollers 140 and one or more actuators 148, which are coupled to the feed spool 135 and/or take-up spool 136, that are adapted to feed and retain a supporting material 137 positioned across a platen 138. The platen 138 generally has a substrate supporting surface on which the substrate 250 and supporting material 137 are positioned during the screen printing process performed in the screen print chamber 102. In one embodiment, the supporting material 137 is a porous material that allows a substrate 250, which is disposed on one side of the supporting material 137, to be retained on the platen 138 by a vacuum applied to the opposing side of the supporting material 137 by a conventional vacuum generating device (*e.g.*, vacuum pump, vacuum ejector). In one embodiment, a vacuum is applied to vacuum ports (not shown) formed in the substrate supporting surface of the platen 138 so that the substrate 250 can be "chucked" to the substrate supporting surface of the platen 138. In one embodiment, the supporting material 137 is a transpirable material that consists, for instance, of a transpirable paper of the type used for cigarette rolling paper or another analogous material, such as a plastic or textile material that performs the same function.

In one configuration, the actuators 148 are coupled to, or are adapted to engage with, the feed spool 135 and the take-up spool 136 so that the movement of a substrate 250 positioned on the supporting material 137 can be accurately controlled within the printing nest 131. In one embodiment, the feed spool 135 and take-up spool 136 are each adapted to receive opposing ends of a length of the supporting material 137. In one embodiment, the actuators 148 each contain one or more drive wheels 147 that are coupled to, or in contact with, the surface of the supporting material 137 positioned on the feed spool 135 and/or the take-up spool 136 to control the motion and position of the supporting material 137 across the platen 138.

Each of the screen print chambers 102 in the print systems described with reference to Figures 1-6 is adapted to deposit material in a desired pattern on the surface of a substrate 250 positioned on a printing nest 131 in position "2" during the screen printing process. In one embodiment, the screen print chamber 102 includes a plurality of actuators, for example, actuators 102A (*e.g*., stepper motors or servomotors) that are in communication with the system controller 101 and are used to adjust the position and/or angular orientation of a screen printing mask 102B (Figures 1 and 5) disposed within the screen print chamber 102 with respect to the substrate 250 being printed. In one embodiment, the screen printing mask 102B is a metal sheet or plate with a plurality of distinctive features 102C (Figures 1 and 5), such as holes, slots, or other apertures formed therethrough to define a pattern and placement of screen printed material (*i.e*., ink or paste) on a surface of a substrate 250. In general, the screen printed pattern that is to be deposited on the surface of a substrate 250 is aligned to the substrate 250 in an automated fashion by orienting the screen printing mask 102B in a desired position over the substrate surface using the actuators 102A and information received by the system controller 101 from the inspection assembly 200. In one embodiment, the screen print chamber 102 is adapted to deposit a metal containing or dielectric containing material on a solar cell substrate 250 having a width between about 125 mm and 156 mm and a length between about 70 mm and about 156 mm. In one embodiment, the screen print chamber 102 is adapted to deposit a metal containing paste on the surface of the substrate 250 to form the metal contact structure on the surface of a substrate.

With each of the screen print systems 110 shown in Figures 1-6, an inspection assembly 200 is associated, adapted to inspect a substrate 250 disposed on the printing nest 131 on which the desired pattern is printed by means of screen printing.

The inspection assembly 200 is adapted to identify and inspect the substrates 250 before and after printing and may comprise one or more cameras 121 (e.g., CCD camera) and other electronic components capable of inspecting and communicating the inspection results to the system controller 101 used to analyze the orientation and position of the substrate 250 on the printing nest 131.

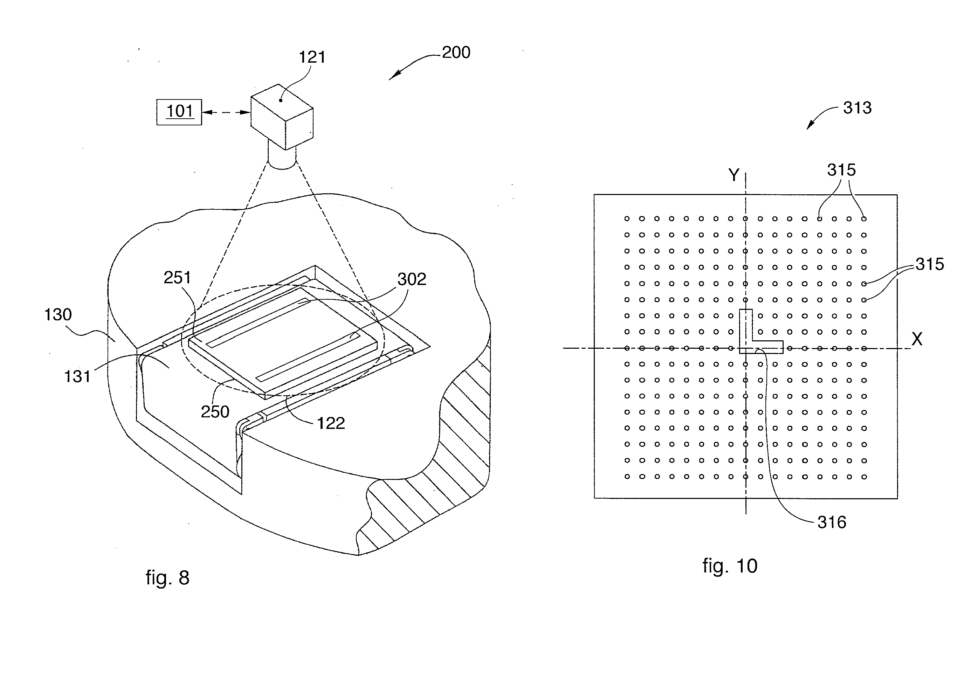

In one embodiment, a camera 121 in Figure 8 is positioned over the surface 251 of the substrate 250 so that a viewing area 122 of the camera 121 can inspect at least one region of the surface 251. As described above, the information received by the camera 121 is used both to align the screen printing mask 102B and thus the subsequently deposited material, and also to acquire an image of the layer deposited on the substrate 250.

In one embodiment, the camera 121 is an InGaAs type camera that has a cooled CCD array to enhance the signal-to-noise ratio of the detect signal. In some configurations, it is desirable to isolate the inspection assembly 200 from ambient light by enclosing or shielding the areas between the surface 251 of the substrate 250 and the camera 121.

In one embodiment, the inspection assembly 200 also includes one or more optical filters (not shown) that are disposed between the camera 121 and the surface 251 of the substrate 250. In this configuration, the optical filter(s) is/are selected to allow only certain desired wavelengths to pass to the camera 121 to reduce the amount of unwanted energy being received by the camera 121 to improve the signal-to-noise ratio of the detected radiation. The optical filter(s) can be a bandpass filter, a narrowband filter, an optical edge filter, a notch filter, or a wideband filter purchased from, for example, Barr Associates, Inc. or from Andover Corporation.

The system controller 101 facilitates the control and automation of the overall screen printing system 110 and may include a central processing unit (CPU) (not shown), memory (not shown), and support circuits (or I/O) (not shown). The CPU may be one of any form of computer processors that are used in industrial settings for controlling various chamber processes and hardware (*e.g*., conveyors, optical inspection assemblies, motors, fluid delivery hardware, etc.) and monitor the system and chamber processes (*e.g*., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate optical inspection system information, and any other corresponding combination.

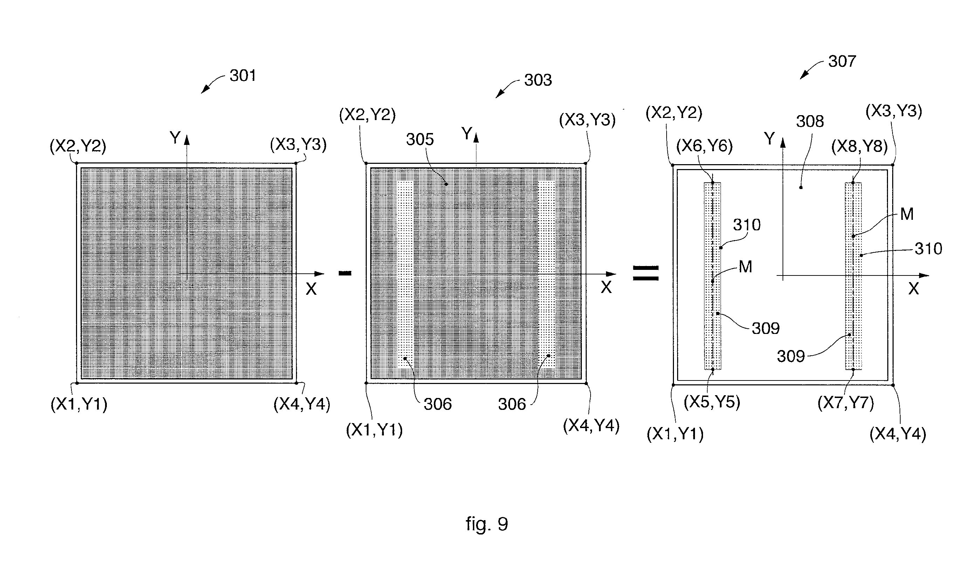

Figure 9 provides a method to control the printing of a pattern printed on a substrate. The control method provides a first acquisition step in which the camera 121 acquires a first image 301 relating to the substrate 250 which is disposed in the screen print chamber 102 (Figures 1-6) before the substrate 250 is printed.

In particular, the substrate 250 arriving from the input conveyor 111 is disposed in position "1" to be transferred, at the suitable moment, to the print position "2". When the substrate 250 is in position "2", and before the printing process starts, the camera 121 detects the position of the substrate with respect to the printing nest 131 and acquires the first image 301 thereof.

In one embodiment, the first image 301 is nothing more than a photograph of the surface 251 on which, during the printing operations, print tracks 302 are printed according to a desired pattern. As previously described, the surface 251, in this case the lower surface, also called back side, of the substrate 250 on which the print tracks 302 are deposited, is near to dark gray in color. In fact, the surface 251 is normally covered with a dielectric or metal material, such as for example aluminum.

The first image 301 acquired is suitably processed by the controller 101, divided into a plurality of elementary units of the image, *i.e.,* a plurality of pixels, and saved in the memory of the controller 101. During this operation, the geometric properties of the substrate 250 are determined, for example determining the positions of the vertexes of the substrate 250.

With reference to the attached drawings, the substrate 250 is substantially rectangular in shape and therefore the positions of the four vertexes of the substrate 250 are evaluated.

More specifically, in the first image 301 (Figure 9), a first pair of coordinates (X1, Y1), a second pair of coordinates (X2, Y2), a third pair of coordinates (X3, Y3), and a fourth pair of coordinates (X4, Y4) are determined. It is quite evident that to determine the position of the substrate 250 and the characteristics of the substrate 250, it would be sufficient to determine three of the four pairs of coordinates.

In the first step of acquiring the image, steps to align the substrate 250 with respect to the printing nest 131 may also be provided, as will be described hereafter, to allow the correct deposit of the print tracks 302 on the substrate 250. Subsequently, in the screen print chamber 102, the print tracks 302 are deposited, usually of conductive material, such as for example silver, aluminum, or silver and aluminum, which have the gray color that is not very different from the color of the deposition surface 251 of the substrate 250. As soon as the print operations have finished, the same camera 121 acquires a second image 303 of the deposition surface 251 of the substrate 250, on which the print track 302 is deposited.

The second image 303 acquired has a first zone 305 on which no material has been deposited, and a plurality of second zones 306 representing the print tracks 302. The second zones 306 are difficult to distinguish from the first zone 305, given that the contrast between the print tracks 302 and the surface 251 is minimal, *i.e.*, the shades of color are not very and easily distinguishable. This makes it difficult to obtain a direct determination of the position of the print tracks 302 on the substrate 250 by means of a direct acquisition of the second image 303.

To this purpose, in one embodiment, the method provides a comparison step to compare the first 301 and second image 303. More specifically, during the comparison step, the first, second, third and fourth pairs of coordinates are also associated with the second image 303. In other words, the respective centers are made to coincide with the first image 301, and the second image 303, by overlapping at least three of the four coordinates detected. This allows to adjust the position of the second image 303 with respect to the first image 301, in order to obtain a perfect overlap of the two. The second image 303 is also divided into a plurality of elementary units or pixels, advantageously using the same division method as for the first image 301.

During the comparison step, moreover, a sub-step is provided during which the second image 303 is subtracted from the first image 301, so that each pixel of the second image 303 is subtracted from a corresponding pixel disposed in a corresponding position of the first image 301. Therefore, from the subtraction operation, a third image 307 is obtained, without the background component of the deposition surface 251 on which no print track 302 has been deposited. The third image 307 is therefore defined by a third zone 308, corresponding to the surface 251 on which there are no print tracks 302, and a fourth zone 309 corresponding to the position where there are print tracks 302 present.

Following the comparison of the images as described above, the fourth zone 309 is very well contrasted with respect to the third zone 308. When the third image 307 has been determined, the controller 101 is adapted to distinguish and determine contours 310 of each of the print tracks 302. In particular, the controller 101 associates with each of the contours 310 relating to the print tracks 302 characteristic points that allow to determine the position assumed by each print track 302 with respect to the deposition surface 251. For example, with each of the four zones 309 relating to the print tracks 302 median lines M are associated, which identify the deposition of the print tracks 302 on the substrate 250.

With each of the fourth zones 309, in this case, two pairs of coordinates are associated, in this case a fifth pair of coordinates (X5, Y5), a sixth pair of coordinates (X6, Y6) for one of the fourth zones 309, and a seventh pair of coordinates (X7, Y7) and an eighth pair of coordinates (X8, Y8) for the other one of the fourth zones 309. For the fourth and fifth pair of coordinates one of the median lines M is disposed through, whereas for the sixth and seventh pair of coordinates the other one of the median lines M passes. It is therefore possible to determine precisely the position of the individual print tracks 302 with respect to the surface 251 of the substrate 250.

The correct positioning of the substrate 250 on the printing nest 131 and the determination of a Cartesian reference system X, Y is obtained by a first step of calibrating the inspection assembly 200 to allow the controller 101 to determine a reference system to be applied during the printing process.

The initial calibration step is performed, for example, at the start of the printing process, or if the cameras are replaced, or when print parameters are modified, such as for example the distance between the screen print chamber 102 and the substrate 250.

The calibration step is achieved by means of a calibration substrate 313 (Figure 10), which is substantially the same shape and size as an optimal substrate 250. In particular, the calibration substrate 313 is provided with reference elements, in this case a plurality of screen printed balls 315 made in the surface of the calibration substrate 313 and according to a matrix configuration in lines and columns; in this case there are seventeen screen printed balls 315 both per line and per column. In a central position of the substrate 313 an L-shaped element 316 is also made, *i.e.,* with the two sides substantially orthogonal with respect to each other.

During the calibration step the calibration substrate 313 is disposed on the printing nest 131 and the camera 121 detects a sample image which is sent to the controller 101.

Depending on the sample image detected, and hence on the position of the screen printed balls 315 and of the shaped element 316, the controller 101 is adapted to center the calibration substrate 313 and to associate with the calibration substrate 313 a system of Cartesian coordinates X, Y which will later be taken into consideration to detect the first 301 and second image 303 and therefore to determine the pairs of Cartesian coordinates.

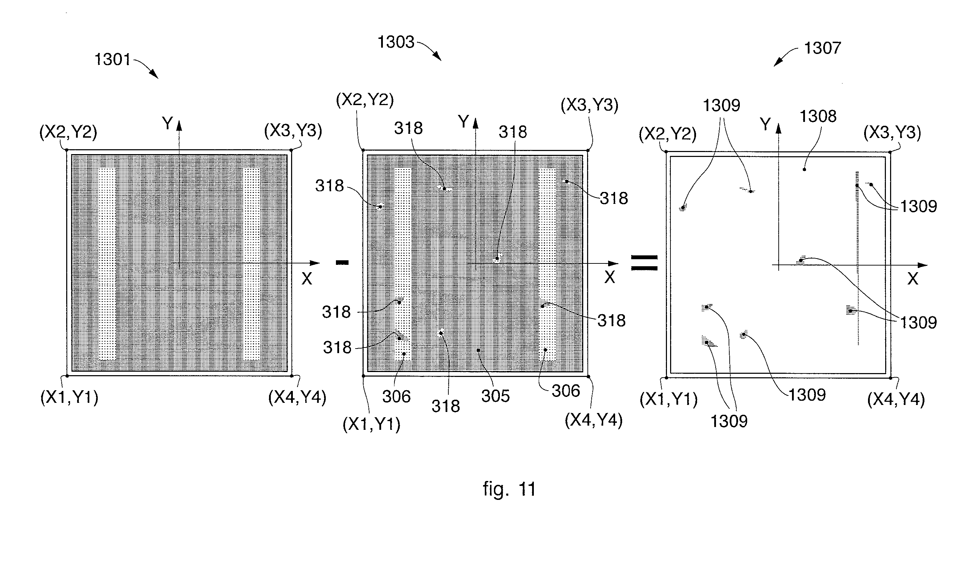

In another embodiment, the method to acquire images in Figure 11 can also be used to control the print quality of the tracks 302 deposited on the substrate 250. This method can be actuated on both surfaces of the substrate 250, *i.e.,* as far as a photovoltaic cell is concerned, both on the captation surface and on the surface where the contacts are made. In this embodiment, a step is provided to detect a reference image 1301 taken by the camera 121. The reference image 1301 is detected from a reference or calibration substrate 250 on which the print tracks 302 have been deposited in an optimum manner. The detection step can be carried out at the start of the printing process, with a substrate 250 on which the print tracks 302 are deemed to have been deposited in an optimum manner, and the reference image 1301 is compared with the images that are detected on each occasion during the printing process. In the same way as for the first image 301 described above, the reference image 1301 too is suitably processed by the controller 101, divided into a plurality of elementary image units, or a plurality of pixels, and stored in the memory of the controller 101. For the reference image 1301 as well, the geometrical properties of the substrate 250 are determined, *i.e.,* a first pair of coordinates (X1, Y1), a second pair of coordinates (X2, Y2), a third pair of coordinates (X3, Y3), and a fourth pair of coordinates (X4, Y4) are determined.

During the printing process, once the print tracks 302 have been deposited on the substrate 250, the camera 121 detects a second image 1303 of the surface 251, in which possible imperfections 318 of the printing process are detected, such as for example spots, interruptions, possible misalignments of the print tracks or other. The second image 1303 is divided into a plurality of elementary image units, *i.e.,* a plurality of pixels, and is stored in the memory of the controller 101. For the second image 1303 too, the coordinates of the vertexes of the substrate 250 are determined, *i.e.,* the pairs of coordinates determined for the reference image 1301. In this way it is possible to determine, during a subsequent step of comparing the reference image 1301 and the second image 1303, a perfect overlapping of the two images.

During the comparison step, the individual elementary units, *i.e.,* the pixels of the reference image 1301 and the second image 1303, are subtracted from each other.

From the subtraction operation a third image 1307 is therefore obtained, without the background component of surface 251, and without the component relating to the print tracks 302 deposited optimally on the substrate 250. The third image 1307 is therefore defined by a third zone 1308, corresponding to the base components, and by a plurality of fourth zones 1309 corresponding to the imperfections 318.

Following the comparison between the reference image 1301 and the second image 1303, it is therefore possible to obtain a third image 1307 in which only the printing imperfections 318 are identified, and not the corresponding zones of the print tracks 302 as well.

The comparison step allows the controller 101 to distinguish the components deriving from the depositing of the print tracks 302 from the components deriving from the imperfections 318, given that the shades of color of the print tracks and the imperfections are substantially the same, and therefore to understand if the substrate 250 which has been printed can be considered as acceptable in terms of quality or must be discarded.

As mentioned above, it is quite clear that this comparison between the images can also be carried out if the print tracks are in very great contrast to each other, and therefore the problems as described for the first embodiment of the present invention as described above are obviated.

Before the printing process, and once the substrate 250 has been positioned on the printing nest 131, it is possible to provide operations to position the substrate 250 with respect to the screen print mask 102B, in order to prevent misalignments of the print tracks 302 with respect to the substrate 250.

It is quite clear that the control method can be carried out in the same way to control multiple prints made on the substrate 250 too.

While the foregoing is directed to embodiments of the present invention, other and further embodiments of the invention may be devised without departing from the basic scope thereof, and the scope thereof is determined by the claims that follow.

## Claims

1. A method to control the printing of a pattern printed on a substrate (250), such as a wafer to form photovoltaic cells or circuits of the green-tape type, comprising:
printing on a surface (251) of the substrate (250) a plurality of print tracks (302) to define the pattern, and
by means of optical acquisition, verifying the printing of the print tracks on the substrate, wherein the verifying comprises:
acquiring a first reference optical image (301; 1301) of the surface (251) of the substrate, or reference substrate, by means of an inspection unit (200), carried out before printing;
processing the first image (301; 1301), in which a processing unit or controller (101) determines reference geometric coordinates (X1, Y1; X2, Y2; X3, Y3; X4, Y4) of the first image and memorizes the geometric coordinates;
subsequent to the printing, by means of the inspection unit, acquiring a second image (303; 1303) of the surface of the substrate on which the print tracks (302) are printed;
processing the second image (303; 1303) by means of the processing unit or controller (101) that associates the geometric reference coordinates of the first image (301; 1301) to the second image (303; 1303);
the processing unit or controller (101) subtracting point by point the colorings between the first image (301; 1301) and the second image (303; 1303) to obtain a third image (307), in which the differences between the first image and the second image are displayed.

2. The method of claim 1, wherein during the processing of the first and second images, the processing unit or controller (101) subdivides both the first image (301; 1301) and the second image (303; 1303) into a same plurality of elementary image units, and during the subtracting each of the elementary units of the first image is subtracted from a corresponding elementary unit of the second image.

3. The method of claim 1 or 2, wherein in the acquiring the first image is acquired relating to the surface (251) of the substrate (250) on which, in the printing, the print tracks (302) are printed.

4. The method of claim 3, wherein the second image is defined at least by a first zone (305) corresponding to the non-printed surface of the substrate (250), and by a plurality of second zones (306) corresponding to the print tracks (302) deposited on the substrate (250), the at least first zone (305) and the plurality of second zones (306) having color shades which are similar to each other.

5. The method of claim 3 or 4, wherein the third image (307) is defined by at least a third zone (308) corresponding to the non-printed surface of the substrate (250), and by a plurality of fourth zones (309) corresponding to the print tracks (302) deposited on the substrate (250), the third zone (308) and the plurality of fourth zones (309) being distinguishable from each other.

6. The method of claim 5, wherein in the acquiring, the processing unit or controller (101) determines contours (310) of the fourth zones (309) and determines pairs of coordinates which can be associated to the contours (310) in order to evaluate the position assumed by the print tracks (302) with respect to the reference geometric coordinates (X1, Y1; X2, Y2; X3, Y3; X4, Y4).

7. The method of any of the preceding claims, wherein the acquiring provides to acquire the first image relating to the surface of a reference substrate on which print tracks have been deposited.

8. The method of claim 7, wherein in the third image (309) only the zones of the surface (251) of the substrate (250) in which there are printing imperfections (318) are displayed.

9. The method of any of the preceding claims, wherein before the printing and the verifying, a calibration is provided in which an absolute Cartesian reference system (X, Y) is determined in order to evaluate at least the reference geometric coordinates (X1, Y1; X2, Y2; X3, Y3; X4, Y4).

10. The method of claim 9, wherein the calibration provides to detect, by means of the inspection unit (200), a sample image relating to a calibration substrate (313) on which reference elements (315, 316) are transferred.

11. The method of claim 10, wherein the reference elements comprise a plurality of balls (315) made in predetermined positions and according to a matrix configuration.

12. The method of claim 10 or 11, wherein the reference elements comprise a shaped element (316) made in a central position of the calibration substrate (313) and provided with two sides disposed orthogonal with respect to each other.

13. An apparatus to control the printing of a pattern printed on a substrate (250), such as a wafer to form photovoltaic cells or circuits of the green-tape type, comprising:
a printing station (131) adapted to deposit on a surface (251) of the substrate (250) a plurality of print tracks (302) to define the pattern, and
an optical inspection unit to acquire the images of the surface on which the print tracks are printed,
wherein the inspection unit (200) is configured to detect at least a first reference optical image of the surface (251) of the substrate, or reference substrate, and at least a second image (303; 1303) of the surface of the substrate on which the print tracks (302) have been printed,
the apparatus further comprising a processing unit or controller (101) provided with a processor configured to process the first image (301; 1301) and to associate to the first image reference geometric coordinates, and to process the second image (301; 1301) to associate to the second image (303; 1303) the reference geometric coordinates,
the processor being further configured to compare the first image and the second image, by means of a punctual subtraction of the respective colorings so as to obtain a third image (307), in which the differences between the first image and the second image are displayed, the controller (101) also comprising memories to memorize at least the first image (301; 1301).

14. The apparatus of claim 13 adapted for carrying out the method according to any of claims 1 to 12.
